# EUROPÄISCHE PATENTANMELDUNG

(11) **EP 2 031 949 A2**
(43) Veröffentlichungstag der Anmeldung: **04.03.2009**
(21) Anmeldenummer: 08104651.8
(22) Anmeldetag: 07.07.2008
(51) Int. Cl.: H05K 7/20

(54) **Elektrische Baugruppe mit einem elektrischen Bauelement, einer Wärmesenke und einem Wärmeleitelement zwischen Bauelement und Wärmesenke**

(30) Priorität: 30.08.2007 DE 102007041096
(71) Anmelder: ROBERT BOSCH GMBH, 70442 Stuttgart (DE)
(72) Erfinder: Kimmich, Peter, 71101 Schoenaich (DE); Rittner, Martin, 71691 Freiberg (DE)

(57) **Zusammenfassung**

Die Erfindung betrifft eine elektrische Baugruppe mit einem elektrischen Bauelement und mit einer Wärmesenke, wobei zwischen Bauelement und Wärmesenke ein Wärmeleitelement angeordnet ist, das zwischen dem Bauelement und der Wärmesenke elektrisch isolierend wirkt. Es ist vorgesehen, dass das Wärmeleitelement (12) mindestens einen elektrisch leitenden ersten Abschnitt (18) und mindestens einen elektrisch isolierenden zweiten Abschnitt (19) aufweist.

## Beschreibung

Die Erfindung betrifft eine elektrische Baugruppe mit einem elektrischen Bauelement und mit einer Wärmesenke, wobei zwischen Bauelement und Wärmesenke ein Wärmeleitelement angeordnet ist, das zwischen dem Bauelement und der Wärmesenke elektrisch isolierend wirkt.

### Stand der Technik

Eine derartige elektrische Baugruppe ist bekannt. Das elektrische Bauelement ist zum Beispiel ein integrierter Schaltkreis (IC). Dieser integrierte Schaltkreis besteht aus einem Halbleiterchip in einem Bauelementgehäuse, wobei ein als Heat-Slug ausgebildetes bauintern angeordnetes Wärmeableitelement die Abwärme des Halbleiterchips zu einer Außenfläche des Bauelementgehäuses ableitet. Zur Abfuhr der Wärme vom Bauelement zu einer Wärmesenke, wie zum Beispiel einem Kühlkörper mit Lüfter, ist zwischen dem Bauelement und der Wärmesenke ein Wärmeleitelement angeordnet. Dieses Wärmeleitelement ist im einfachsten Fall ein elektrisch isolierender Kleber oder eine elektrisch isolierende Folie. Die Wärmeabfuhr zur Wärmesenke über das Wärmeleitelement kann dabei in Richtung eines Schaltungsträgers zur elektrischen Kontaktierung des Bauelements oder in eine entgegengesetzte Richtung verlaufen. Das Potential der Wärmesenke ist aufgrund der elektrisch isolierenden Wirkung des Wärmeleitelements unabhängig vom Potential des Bauelements. Muss das Wärmeleitelement einen größeren Abstand zwischen dem Bauelement und der Wärmesenke überbrücken, so kommt es aufgrund des Wärmewiderstands Rₜₕ des Wärmeleitelements zu einem schlechten Ableiten der Verlustwärme des Bauelements. Weiterhin ist der Wärmewiderstand abhängig vom zu überbrückenden Abstand.

Aus der US 4,914,551 ist eine elektrische Vorrichtung mit Wärmeverteilkörper bekannt, bei dem der Wärmeverteilkörper zwischen einem Halbleiterchip und einem Kühlkörper angeordnet ist und wobei der Wärmeleitkörper in etwa den gleichen thermischen Ausdehnungskoeffizienten wie der Halbleiterchip aufweist.

### Offenbarung der Erfindung

Um eine gute Ableitung der Verlustwärme des elektrischen Bauelements zu gewährleisten, die unabhängig vom Abstand Bauelement-Wärmesenke ist, ist vorgesehen, dass das Wärmeleitelement mindestens einen elektrisch leitenden ersten Abschnitt und mindestens einen elektrisch isolierenden zweiten Abschnitt aufweist. Da elektrisch leitende Materialien im Allgemeinen auch gut wärmeleitende Materialien, also Materialien mit niedrigem Wärmewiderstand Rₜₕ, sind, weist das Wärmeleitelement mindestens einen elektrisch leitenden und somit auch gut wärmeleitenden ersten Abschnitt auf. Um dennoch die elektrisch isolierende Wirkung zwischen dem Bauelement und der Wärmesenke zu gewährleisten, weist das Wärmeleitelement den elektrisch isolierenden zweiten Abschnitt auf. Der zweite Abschnitt kann dabei so ausgebildet sein, dass er die elektrisch isolierende Wirkung und damit die Trennung der elektrischen Potentiale des Bauelements und der Wärmesenke und gleichzeitig eine fest vorgebbare Wärmeanbindung des Bauelements an die Wärmesenke bewirkt. Gegenüber einem Wärmeleitelement, das nur aus elektrisch isolierendem Material besteht, kann ein deutlich höherer Wärmetransport zwischen Bauelement und Wärmesenke erreicht werden.

In einer vorteilhaften Ausgestaltung der Erfindung ist vorgesehen, dass die Abschnitte - in Wärmeleitrichtung des Wärmeleitelements gesehen - hintereinander angeordnet sind. Durch diese Anordnung ist gewährleistet, dass sich im Wärmeleitelement Wärmeleitpfade zwischen dem Bauelement und der Wärmesenke ausbilden, die durch den mindestens einen elektrisch leitenden ersten Abschnitt und den mindestens einen elektrisch isolierenden zweiten Abschnitt verlaufen.

Mit Vorteil ist weiterhin vorgesehen, dass das Wärmeleitelement mindestens eine erste thermische Anbindung an das Bauelement und mindestens eine zweite thermische Anbindung an die Wärmesenke aufweist. Die thermischen Anbindungen sind elektrisch leitend und/oder elektrisch isolierend. Vorzugsweise ist die erste thermische Anbindung eine Lötverbindung zwischen Wärmeleitelement und Bauelement. Mit Vorteil ist die zweite thermische Anbindung eine elektrisch isolierende Anbindung.

Nach einer Weiterbildung der Erfindung ist vorgesehen, dass die zweite thermische Anbindung eine zweite Anbindungsfläche aufweist, die größer ist als eine erste Anbindungsfläche der ersten thermischen Anbindung. Dabei ist bevorzugt vorgesehen, dass die Wärmeleitfähigkeit im Bereich der zweiten thermischen Anbindung größer ist als die Wärmeleitfähigkeit im Bereich der ersten thermischen Anbindung. Das Wärmeleitelement ist als so genannter Wärmespreizer ausgebildet. In einer vorteilhaften Ausgestaltung wird der Wärmespreizer im Wesentlichen vom elektrisch leitenden ersten Abschnitt gebildet, wobei der vorzugsweise als dünne Schicht ausgebildete elektrisch isolierende zweite Abschnitt im Bereich der zweiten thermischen Anbindung angeordnet ist.

In einer vorteilhaften Weiterbildung der Erfindung ist vorgesehen, dass das Wärmeleitelement als U-förmiges Wärmeleitelement ausgebildet ist, das mit Enden seiner Schenkel an die Wärmesenke und mit seiner Basis an das Bauelement thermisch angebunden ist. Durch die U-förmige Ausbildung des Wärmeleitelements entsteht ebenfalls ein Wärmespreizer.

Alternativ ist mit Vorteil vorgesehen, das Wärmeleitelement als plattenförmiges Wärmeleitelement mit einer Grundfläche und einer von dieser Grundfläche abgehenden, tiefgezogenen Zone ausgebildet ist, wobei die erste thermische Anbindung an dieser Zone und die zweite thermische Anbindung an der Grundfläche erfolgt. Das plattenförmige Wärmeleitelement mit tiefgezogener Zone weist einen ersten Abschnitt, der als Tiefziehteil aus einem Blech ausgebildet ist und einen vorzugsweise als dünne Schicht ausgebildeten zweiten Abschnitt auf, wobei diese Schicht an der Zone und/oder an der Grundfläche ausgebildet ist.

In einer vorteilhaften Ausgestaltung der Erfindung ist vorgesehen, dass das Bauelement mindestens ein elektrisches Element, ein das elektrische Element umgebendes Bauelementgehäuse und ein Wärmeableitelement aufweist, das die Abwärme des elektrischen Elements zu einer Außenfläche des Bauelementgehäuses ableitet. Ein derartiges Bauelement ist insbesondere ein Halbleiterbauelement mit einem als Halbleiterchip (Die) ausgebildeten elektrischen Element, einem Bauelementgehäuse und einem als Heat-Slug ausgebildeten Wärmeableitelement. Der Heat-Slug leitet die Abwärme des Halbleiterchips zu einer der Außenflächen des Bauelementgehäuses. Das Wärmeleitelement ist an diese Außenfläche thermisch angebunden (erste thermische Anbindung) und leitet die Wärme an die Wärmesenke ab.

In einer vorteilhaften Ausgestaltung der Erfindung ist vorgesehen, dass die Wärmesenke von einem Kühlkörper gebildet wird. Der Kühlkörper kann zum Beispiel über das Wärmeleitelement auf dem elektrischen Bauelement befestigt sein.

Weiterhin ist mit Vorteil vorgesehen, dass die Baugruppe einen Schaltungsträger aufweist, auf dem das Bauelement angeordnet ist. Der Schaltungsträger dient zur elektrischen Kontaktierung des Bauelements. Prinzipiell ergeben sich zwei Alternativen zur Anordnung des Wärmeleitelements bezüglich des Schaltungsträgers: Eine thermische Anbindung des Wärmeleitelements an das Bauelement in Richtung der Kontaktierung mit dem Schaltungsträger oder eine thermische Anbindung des Wärmeleitelements an das Bauelement in entgegengesetzter Richtung zu der Kontaktierung mit dem Schaltungsträger. Bevorzugt ist eine Anordnung des Wärmeleitelements vorgesehen, bei der dieses auf einer dem Schaltungsträger abgewandten Seite des Bauelements an dieses thermisch angebunden ist. Somit erfolgt die thermische Anbindung des Bauelements in entgegengesetzter Richtung zu seiner elektrischen Kontaktierung. Ein derartiges Konzept ist für Bauelemente mit elektrischem Element, Wärmeableitelement und Bauelementgehäuse ist als "Slug-Up"-Geometrie bekannt.

Schließlich ist mit Vorteil vorgesehen, dass die Wärmesenke von einem Gehäuseteil eines den Schaltungsträger umgebenden Gehäuses gebildet wird.

Das Gehäuseteil ist insbesondere ein Gehäusedeckel, vorzugsweise ein Gehäusedeckel aus Metall. Ein derartiger Gehäusedeckel aus Metall ist zum Beispiel ein Aluminium-Druckguss-Gehäusedeckel.

### Kurze Beschreibung der Zeichnungen

Im Folgenden soll die Erfindung anhand von Zeichnungen näher erläutert werden. Dazu zeigen:
- Figur 1: eine elektrische Baugruppe mit einem elektrischen Bauelement, einer Wärmesenke und einem Wärmeleitelement in einer schematischen Darstellung,
- Figur 2: die elektrische Baugruppe mit dem Wärmeleitelement in einer ersten Ausführungsform,
- Figur 3: das Wärmeleitelement in einer zweiten Ausführungsform und
- Figur 4: das Wärmeleitelement in einer dritten Ausführungsform.

### Ausführungsform(en) der Erfindung

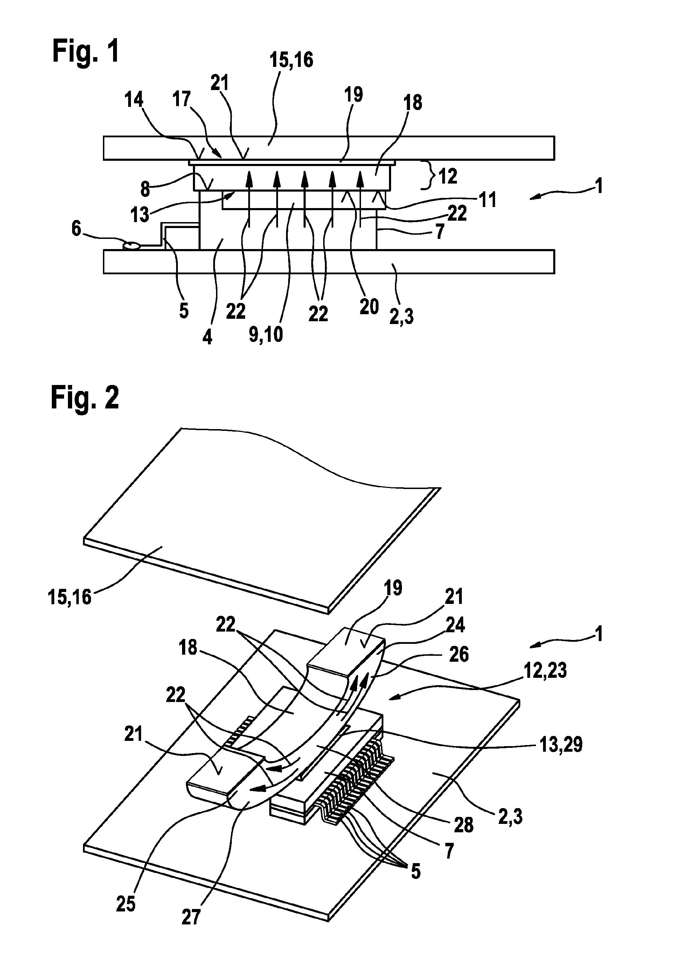

Die Figur 1 zeigt in einer schematischen Darstellung eine elektrische Baugruppe 1. Die elektrische Baugruppe 1 ist zum Beispiel Teil einer Schaltungsanordnung, insbesondere Teil einer Schaltungsanordnung einer Leistungselektronik. Auf einem als Leiterplatte 2 ausgebildeten Schaltungsträger 3 ist ein elektrisches Bauelement 4 angeordnet, das Kontaktelemente 5 aufweist, mit denen es mit nicht dargestellten Leiterbahnen des Schaltungsträgers 3 über Lötverbindungen 6 elektrisch kontaktiert ist.

Das elektrische Bauelement 4 weist ein Bauelementgehäuse 7 auf, das an seiner dem Schaltungsträger 3 abgewandten Oberseite 8 eine als Kühlfläche 9 ausgebildete Außenfläche 10 aufweist. Die Außenfläche 10 ist bauelementintern über ein als Heat-Slug ausgebildetes Wärmeableitelement (nicht dargestellt) mit einem als Halbleiterchip ausgebildeten elektrischen Element (ebenfalls nicht dargestellt) des Bauelements 4 verbunden.

Das Bauelement 4 ist auf seiner Oberseite 8 an seiner Unterseite 11 eines Wärmeleitelements 12 angebunden. Zwischen dem Bauelement 4 und dem Wärmeleitelement 12 entsteht dadurch eine erste thermische Anbindung 13. Das Wärmeleitelement 12 ist mit seiner Oberseite 14 an eine als Gehäuseteil 15 ausgebildete Wärmesenke 16 verbunden. Durch die Verbindung entsteht eine zweite thermische Anbindung 17 des Wärmeleitelements 12 an die Wärmesenke 16. Das Wärmeleitelement 12 weist einen elektrisch leitenden ersten Abschnitt 18 und einen elektrisch isolierenden zweiten Abschnitt 19 auf. Der erste Abschnitt 18 des Wärmeleitelements ist dem Bauelement 4 zugewandt und der zweite Abschnitt 19 des Wärmeleitelements 12 ist der Wärmesenke 16 zugewandt.

Es ergibt sich folgende Funktion der elektrischen Baugruppe 1: Während das Bauelement 4 über seine Kontaktelemente 5 und Lötverbindungen 6 zwischen den Kontaktelementen 5 und Leiterbahnen des Schaltungsträgers 3 elektrisch "nach unten" kontaktiert ist, erfolgt eine Wärmeabfuhr über die Oberseite 8 des elektrischen Bauelements 4 "nach oben". Dazu ist das Bauelement 4 an seiner Oberseite 8 über eine erste Anbindungsfläche 20 der ersten thermischen Anbindung 13 mit dem Wärmeleitelement 12 verbunden. Über eine zweite Anbindungsfläche 21 der zweiten thermischen Anbindung 17 ist das Wärmeleitelement 12 an die Wärmesenke 16 thermisch angebunden.

Im Betrieb des elektrischen Bauelements 4 entsteht bauelementintern Wärme, die das elektrische Bauelement 4 auf eine Temperatur T₁ erwärmt, die deutlich größer ist als eine Temperatur T₂ der Wärmesenke 16. Die Temperaturdifferenz ΔT = T₁ - T₂ zwischen Bauelement 4 und Wärmesenke 16 verursacht eine Wärmeleitung mit einer Wärmeleitrichtung (Pfeile 22) vom elektrischen Bauelement 4 über das Wärmeleitelement 12 zur Wärmesenke 16. Gleichzeitig wirkt das Wärmeleitelement 12 zwischen dem elektrischen Bauelement 4 und der Wärmesenke 16 elektrisch isolierend. Dazu weist das Wärmeleitelement 12 neben dem elektrisch leitenden ersten Abschnitt 18 den elektrisch isolierenden zweiten Abschnitt 19 auf. Die beiden Abschnitte 18, 19 sind dabei in Wärmeleitrichtung (Pfeile 22) gesehen hintereinander angeordnet. Durch die Verwendung des elektrisch leitenden ersten Abschnitts 18 ist die Wärmeleitfähigkeit des Wärmeleitelements 12 gegenüber einem entsprechenden Wärmeleitelement, das ausschließlich aus mindestens einem elektrisch isolierenden Material besteht, deutlich erhöht (etwa 60 W/mK gegenüber 2 W/mk). Um weiterhin eine elektrisch isolierende Wirkung zwischen dem elektrischen Bauelement 4 und der Wärmesenke 12 - also eine Trennung ihrer elektrischen Potentiale - zu erreichen, weist das Wärmeleitelement 12 neben dem elektrisch leitenden ersten Abschnitt den elektrisch isolierenden zweiten Abschnitt 19 auf.

Bei einem derartig ausgebildeten Wärmeleitelement 12 mit mindestens einem elektrisch leitenden ersten Abschnitt 18 und mindestens einem elektrisch isolierenden zweiten Abschnitt 19 kann dieser zweite Abschnitt 19 gerade so dimensioniert sein, dass eine hinreichend isolierende Wirkung zwischen elektrischem Bauelement 4 und Wärmesenke 16 gewährleistet ist. Der Rest des Wärmeleitelements 12 kann als elektrisch leitender erster Abschnitt 18 ausgebildet sein, wodurch die Wärmeleitfähigkeit des Wärmeleitelements 12 gegenüber einem Wärmeelement, das nur aus elektrisch isolierendem Material besteht, deutlich erhöht ist. Da die spezifische Wärmeleitfähigkeit des Materials des ersten Abschnitts 18 um mindestens eine Größenordnungen größer ist als die spezifische Wärmeleitfähigkeit des Materials des zweiten Abschnitts 19, sind die Abschnitte 18, 19 des Wärmeleitelement 4 insbesondere dimensioniert, dass die Wärmeleitfähigkeit des Wärmeleitelement 4 durch den zweiten Abschnitt begrenzt ist. Die Wärmeleitfähigkeit eines derartigen Wärmeleitelements 12 ist im Wesentlichen unabhängig von seiner Gesamtgeometrie beziehungsweise Gesamtgröße, da die Geometrie des zweiten Abschnitts 19 lediglich von dessen elektrischen Isolationseigenschaften bestimmt wird.

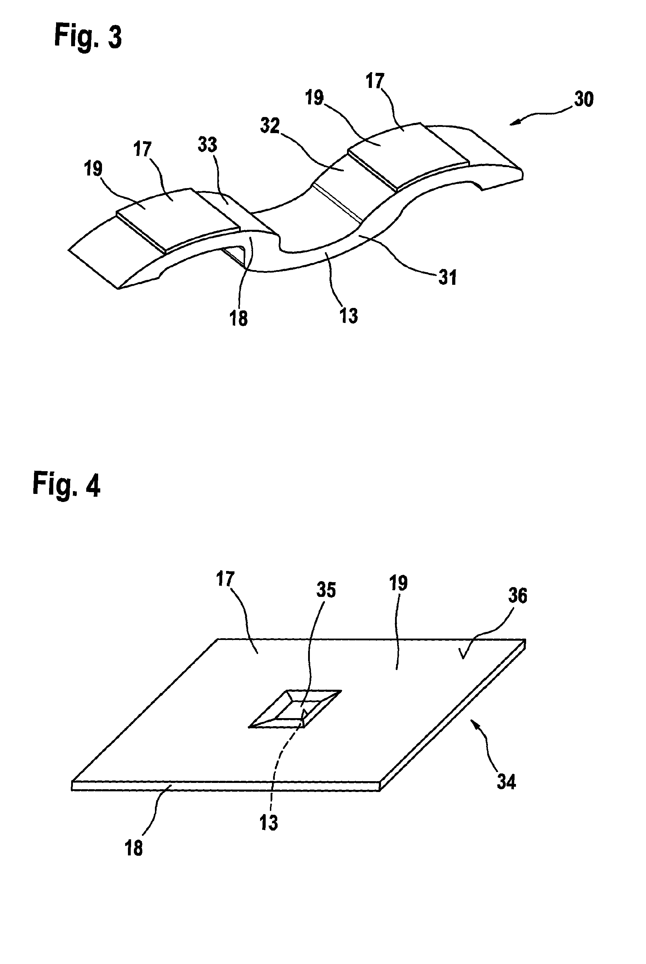

Die Figur 2 zeigt eine weitere Ausführungsform der Erfindung, die im Wesentlichen der Ausführungsform der Figur 1 entspricht, sodass hier nur auf die Unterschiede eingegangen wird. Das Wärmeleitelement 12 der Figur 2 ist als U-förmiges Wärmeleitelement 23 ausgebildet, das mit Enden 24, 25 von Schenkeln 26, 27 seiner U-Form an die als Gehäuseteil 15 ausgebildete Wärmesenke 16 und mit einer Basis 28 der U-Form an die Oberseite 14 des elektrischen Bauelements 4 thermisch angebunden ist. Das U-förmige Wärmeleitelement 23 der Figur 2 weist ebenfalls zwei unterschiedliche Abschnitte 18, 19 auf, wobei der erste Abschnitt elektrisch leitend ist und über die als Lötstelle 29 ausgebildete erste thermische Anbindung 13 an der Basis elektrisch leitend mit dem Bauelementgehäuse 7 des elektrischen Bauelements 4 verbunden ist. Die elektrisch isolierenden zweiten Abschnitte 19 sind als dünne Schichten an den Enden 24, 25 der Schenkel 26, 27 der U-Form des Wärmeleitelements 12 angeordnet. Das U-förmige Wärmeleitelement 23 wirkt - wie auch die Wärmeleitelemente der Figuren 3 und 4 - als Wärmespreizer.

Bei einem Wärmespreizer ist die Summe der ersten Anbindungsflächen 20 der ersten thermischen Anbindung 13 zwischen Wärmeleitelement 12 und Bauelement kleiner als die Summe der zweiten Anbindungsflächen 21 der zweiten thermischen Anbindung 17 zwischen dem Wärmeleitelement 12 und der Wärmesenke 16.

Die Figur 3 zeigt eine weitere Ausführungsform eines Wärmeleitelements 12, wobei dieses als wellenförmiges Wärmeleitelement 30 ausgebildet ist. Das wellenförmige Wärmeleitelement 30 wird mit einem Wellental 31 an das elektrische Bauelement 4 und mit zwei Wellenbergen 32, 33 an die Wärmesenke 16 thermisch angebunden. Das wellenförmige Wärmeleitelement 23 der Figur 2 weist ebenfalls zwei unterschiedliche Abschnitte 18, 19 auf, wobei der erste Abschnitt elektrisch leitend ist und über die bevorzugt als Lötstelle 29 ausgebildete erste thermische Anbindung 13 am Wellental 31 elektrisch leitend mit dem Bauelementgehäuse 7 des elektrischen Bauelements 4 verbunden ist. Die elektrisch isolierenden zweiten Abschnitte 19 sind als dünne Schichten an den Wellenberge 32 des wellenförmigen Wärmeleitelements 30 angeordnet.

Die Figur 4 zeigt ein weitgehend plattenförmiges Wärmeleitelement 34 mit einer tiefgezogenen Zone 35, wobei die erste thermische Anbindung 13 an dieser Zone 35 und die zweite thermische Anbindung 17 an einer verbleibenden Grundfläche 36 des plattenförmigen Wärmeleitelements 34 erfolgt. Bildet die tiefgezogene Zone 35 die erste Anbindungsfläche 20 und die Grundfläche 36 die zweite Anbindungsfläche 21, so wirkt das plattenförmige Wärmeleitelement 34 als Wärmespreizer. Das plattenförmige Wärmeleitelement 34 besteht ebenfalls aus mindestens einem elektrisch leitenden ersten Abschnitt 18 und mindestens einem elektrisch isolierenden zweiten Abschnitt 19. Bevorzugt besteht das plattenförmige Wärmeleitelement 34 aus einem als dünne Schicht ausgebildeten zweiten Abschnitt 19, der die Grundfläche 36 bildet mit einem elektrisch leitenden Abschnitt 2, der den Rest des plattenförmigen Wärmeleitelements 34 inklusive der tiefgezogenen Zone 35 bildet.

Es ergeben sich folgende vorteilhafte Ausgestaltungen des Wärmeleitelements 12:
- Verbesserung der Wärmeleitfähigkeit durch Ausbildung der ersten thermischen Anbindung 13 als Lötstelle 29,
- Vorbeloten des Wärmeleitelements 12 an der ersten thermischen Anbindung 13, sodass nach einem Flussmittelauftrag ein gleichzeitiges Anlöten der Kontaktelemente des elektrischen Bauelements 4 auf dem Schaltungsträger 3 und des Wärmeleitelements 12 auf dem elektrischen Bauelement 4 erfolgen kann,
- Ausbildung des elektrisch isolierenden zweiten Abschnitts 19 aus polymerem Wärmeleitmedium und des elektrisch leitenden ersten Abschnitts 18 aus Metall, insbesondere einem Metall auf Basis von Kupfer, Aluminium oder Eisen,
- Ausbildung des Wärmespreizers als eindimensionaler Wärmespreizer (zum Beispiel U-, V- oder Doppel-S- beziehungsweise Wellenform) oder dreidimensional (zum Beispiel als plattenförmiges Wärmeleitelement 34 mit tiefgezogener Zone 35).

## Patentansprüche

1. Elektrische Baugruppe mit einem elektrischen Bauelement und mit einer Wärmesenke, wobei zwischen Bauelement und Wärmesenke ein Wärmeleitelement angeordnet ist, das zwischen dem Bauelement und der Wärmesenke elektrisch isolierend wirkt, **dadurch gekennzeichnet, dass** das Wärmeleitelement (12) mindestens einen elektrisch leitenden ersten Abschnitt (18) und mindestens einen elektrisch isolierenden zweiten Abschnitt (19) aufweist.

2. Baugruppe nach Anspruch 1, **dadurch gekennzeichnet, dass** die Abschnitte (18,19) - in Wärmeleitrichtung des Wärmeleitelements (12) gesehen - hintereinander angeordnet sind.

3. Baugruppe nach einem der vorhergehenden Ansprüche, **dadurch gekennzeichnet, dass** das Wärmeleitelement (12) mindestens eine erste thermische Anbindung (13) an das Bauelement (4) und mindestens eine zweite thermische Anbindung (17) an die Wärmesenke (16) aufweist.

4. Baugruppe nach einem der vorhergehenden Ansprüche, **dadurch gekennzeichnet, dass** die zweite thermische Anbindung (17) eine zweite Anbindungsfläche (21) aufweist, die größer ist als eine erste Anbindungsfläche (20) der ersten thermischen Anbindung (13).

5. Baugruppe nach einem der vorhergehenden Ansprüche, **dadurch gekennzeichnet, dass** das Wärmeleitelement (12) als plattenförmiges Wärmeleitelement (34) mit einer Grundfläche (36) und einer von dieser Grundfläche abgehenden tiefgezogenen Zone (35) ausgebildet ist, wobei die erste thermische Anbindung (13) an dieser Zone (35) und die zweite thermische Anbindung (17) an der Grundfläche (36) erfolgt.

6. Baugruppe nach einem der vorhergehenden Ansprüche, **dadurch gekennzeichnet, dass** das Wärmeleitelement (12) als U-förmiges Wärmeleitelement (23) ausgebildet ist, das mit Enden (24,25) seiner Schenkel (26,27) an die Wärmesenke (16) und mit seiner Basis (28) an das Bauelement (4) thermisch angebunden ist.

7. Baugruppe nach einem der vorhergehenden Ansprüche, **dadurch gekennzeichnet, dass** das Bauelement (4) mindestens ein elektrisches Element, ein das elektrische Element umgebendes Bauelementgehäuse (7) und ein Wärmeableitelement aufweist, das die Abwärme des elektrischen Elements zu einer Außenfläche (10) des Bauelementgehäuses (7) ableitet.

8. Baugruppe nach einem der vorhergehenden Ansprüche, **dadurch gekennzeichnet, dass** die Wärmesenke (16) von einem Kühlkörper gebildet wird.

9. Baugruppe nach einem der vorhergehenden Ansprüche, **gekennzeichnet durch** einen Schaltungsträger (3), auf dem das Bauelement (4) angeordnet ist.

10. Baugruppe nach einem der vorhergehenden Ansprüche, **dadurch gekennzeichnet, dass** die Wärmesenke (16) von einem Gehäuseteil (15) eines den Schaltungsträger (3) umgebenden Gehäuses gebildet wird.
